(19) Europäisches Patentamt / European Patent Office / Office européen des brevets

(11) **EP 2 810 372 B1**

(12) **EUROPEAN PATENT SPECIFICATION**

(45) Date of publication and mention
of the grant of the patent:
**03.04.2019 Bulletin 2019/14**

(21) Application number: **12867539.4**

(22) Date of filing: **24.02.2012**

(51) Int Cl.:
**H03M 13/27** *(2006.01)*       **H03M 13/39** *(2006.01)*

(86) International application number:
**PCT/KR2012/001441**

(87) International publication number:
**WO 2013/115429 (08.08.2013 Gazette 2013/32)**

(54) **APPARATUS AND METHOD FOR GENERATING INTERLEAVER INDEX**

VORRICHTUNG UND VERFAHREN ZUR ERZEUGUNG EINES VERSCHACHTELUNGSINDEX

APPAREIL ET PROCÉDÉ PERMETTANT DE GÉNÉRER UN INDICE D'ENTRELACEMENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **02.02.2012 KR 20120010658**

(43) Date of publication of application:
**10.12.2014 Bulletin 2014/50**

(73) Proprietor: **Innowireless Co., Ltd.
Seongnam-si, Gyeonggi-do 13590 (KR)**

(72) Inventors:
• **JOUNG, Jinsoup**
Seongnam-si
Gyeonggi-do 463-500 (KR)
• **LEE, Joohyeong**
Seoul 135-270 (KR)
• **LIM, Jongho**
Seoul 138-796 (KR)
• **KIM, Jaehwan**
Seongnam-si
Gyeonggi-do 463-856 (KR)

(74) Representative: **Staeger & Sperling
Partnerschaftsgesellschaft mbB
Sonnenstraße 19
80331 München (DE)**

(56) References cited:
WO-A2-2008/057041      JP-A- H05 145 429
KR-A- 20090 003 986      KR-B1- 100 943 612
US-A1- 2007 220 377      US-A1- 2009 138 668

• YANG SUN ET AL: "Efficient hardware implementation of a highly-parallel 3GPP LTE/LTE-advance turbo decoder", INTEGRATION, THE VLSI JOURNAL, vol. 44, no. 4, 17 July 2010 (2010-07-17), pages 305-315, XP028257389, ISSN: 0167-9260, DOI: 10.1016/J.VLSI.2010.07.001 [retrieved on 2010-07-17]
• RIZWAN ASGHAR: "Flexible Interleaving Sub-systems for FEC in Baseband Processors", LINKOEPING STUDIES IN SCIENCE AND TECHNOLOGY, LINKOEPINGS UNIVERSITET, LINKOEPING, SE , 2010, pages 1-216, XP007918293, ISSN: 0345-7524 Retrieved from the Internet: URL:http://www.diva-portal.org/smash/get/d iva2:311111/FULLTEXT01.pdf [retrieved on 2015-07-28]

**Description**

[Technical Field]

The present invention relates to an apparatus and a method for generating an interleaver index, and more particularly to an apparatus and a method for generating an internal interleaver index of a turbo encoder in parallel.

[Background Art]

In general, the relation between an input and an output of an internal interleaver of a turbo encoder follows the below equation when inputs are $C_0, C_1, C_2, ... C_{k-1}$ and outputs are $C'_0, C'_1, C'_2, ... C'_{k-1}$.

$$C'_i = C'_{\Pi(i)}, i = 0, 1, 2, ... K-1$$

Further, indexes of an input stream and an output stream follow the below equation.

$$\Pi(i) = (f_1 * i + f_2 * i^2) \bmod K$$

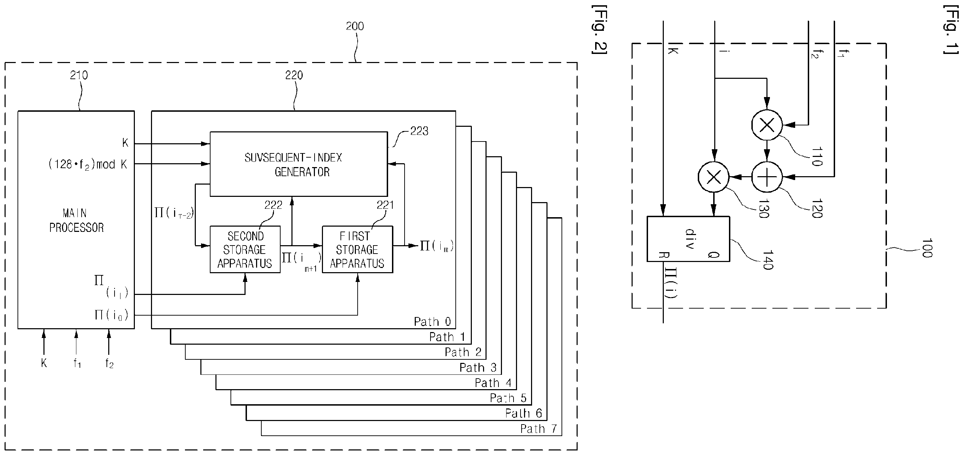

FIG. 1 is a diagram illustrating an apparatus 100 for generating an internal interleaver index of a conventional turbo encoder.

Referring to FIG. 1, the apparatus 100 for generating the internal interleaver index of the conventional turbo encoder includes a first multiplier 110, an adder 120, a second multiplier, and a divider 140.

The apparatus 100 for generating the internal interleaver index of the conventional turbo encoder receives inputs of K, which is a size of input data, $f_1$ and $f_2$ calculated from K, and a value of i according to an order of bits and outputs II(i) satisfying

$$\Pi(i) = (f_1 * i + f_2 * i^2) \bmod K$$ .

The first multiplier 110 receives inputs of $f_2$ and i and outputs a value of $f_2*i$.

The adder 120 receives inputs of i and $f_2*i$ output through the first multiplier 110 and outputs a value of $f_2*i+f_1$.

The second multiplier 130 receives inputs of i and $f_2*i+f_1$ output through the adder 120 and outputs a value of $(f_2*i+f_1)*i$.

The divider 140 receives inputs of K and $(f_2*i+f_1)*i$, performs $(f_2*i+f_1)*i/K$, and then outputs $(f_2*i+f_1)*i \bmod K$ corresponding to the remainder.

The apparatus 100 for generating the internal interleaver index of the conventional turbo encoder outputs the index in the unit of bits, so that the time for generating the index is increased in proportion to the size of the input data. As a result, the performance of the apparatus is deteriorated.

Further, there is a problem in that the apparatus 100 for generating the internal interleaver index of the conventional turbo encoder requires the multiplier and the divider, which have high importance in an aspect of the hardware implementation, in order to generate the index.

[Disclosure]

[Technical Problem]

An aspect of the present invention provides an apparatus and a method for generating an interleaver index, which calculates indexes for following bits by using an index value extracted for a predetermined bit of input data while generating interleaver indexes for a plurality of bits in parallel.

The article "Efficient hardware implementation of a highly-parallel 3GPP LTE/LTE-advance turbo decoder" from YANG SUN ET AL in the Integration, The VLSI Journal vol. 44, no.4, 17 july 2010 (2010-07-17), pages 305-315, XP028257389, ISSN: 0167-9260, DPI:10.1016/J.VLSI.2010.07.001 discloses a VLSI architecture for a 3GPP LTE/LTE Advanced Turbo decoder by utilizing the algebraic-geometric properties of the quadratic permutation polynomial interleaver.

[Technical Solution]

In accordance with an aspect of the present invention, there is provided an apparatus according the features of claim 1. The apparatus is configured for generating indexes of an interleaver for input data, the apparatus including a main processor for calculating an index for a predetermined bit of the input data; and an index operator for receiving the index calculated by the main processor, calculating in parallel indexes for bits after the predetermined bit, and deriving a plurality of indexes.

The main processor or the index operator may calculate the index by using a difference between indexes.

The index for the predetermined bit may be calculated by an equation of

$$\Pi(i+1)-\Pi(i)=(f_1+f_2+2*f_2*i)\mathrm{mod}K$$

A modular operation may be performed using an addition and a multiplexer.

The addition may be an addition of a dividend and a sign inverted divisor of the modular operation, and the multiplexer may receive inputs of a result of the addition and the dividend, wherein the multiplexer may output the dividend when the result of the addition is a negative number and output the result of the addition when the result of the addition is a positive number.

The main processor may calculate indexes for $i^{th}$ to $i+15^{th}$ bits (i is an integer equal to or larger than 0) of the input data, and the index operator may calculate an index for an $(i+j)+16^{th}$ bit ($0 \le j \le 7$) by using a difference between $i+j^{th}$ and $(i+j)+8^{th}$ bits.

The main processor may calculate $(128*f_2)\mathrm{mod}K$ and transfer the calculated $(128*f_2)\mathrm{mod}K$ to the index operator, and the index operator may calculate an index by using an equation of

$$\Pi(i+j+16)=(2*\Pi(i+j+8)-\Pi(i+j)+128*f_2)\mathrm{mod}K \quad (0 \le j \le 7).$$

The modular operation may be performed using a first addition, a second addition, and a multiplexer through receptions of a first input, a second input, and a divisor of K.

The first addition may be an addition of the first input and a sign inverted second input, the second addition may be an addition of a result of the first addition and a divisor of K, and the multiplexer receives inputs of the result of the first addition and a result of the second addition and outputs the result of the second addition when the result of the first addition is a negative number and outputs the result of the first addition when the result of the first addition is a positive number.

In accordance with another aspect of the present invention, there is provided a method of generating indexes of an interleaver for input data, the method including performing a first step by calculating an index for a predetermined bit of the input data; and performing a second step by calculating indexes for bits after the predetermined bit in parallel by using the calculated index.

In the first step, a difference between indexes for bits may be calculated by an equation of $\Pi(i+1)-\Pi(i)=(f_1+f_2+2*f_2*i)\mathrm{mod}K$ and indexes for bits after the bit may be calculated using the calculated index.

A modular operation may be performed using an addition and a multiplexer, wherein the addition may be an addition of a dividend and a sign inverted divisor of the modular operation, and the multiplexer may receive inputs of a result of the addition and the dividend, wherein the multiplexer may output the dividend when the result of the addition is a negative number and output the result of the addition when the result of the addition is a positive number.

$(128*f_2)\mathrm{mod}K$ and indexes for $i^{th}$ to $i+15^{th}$ bits (i is an integer equal to or larger than 0) of the input data may be calculated in the first step, and indexes for bits from an i+16 bit may be calculated using an equation of $\Pi(i+j+16)=(2*\Pi(i+j+8)-\Pi(i+j)+128*f_2)\mathrm{mod}K$ ($0 \le j \le 7$) in the second step.

The modular operation may be performed using a first addition, a second addition, and a multiplexer through receptions of a first input, a second input, and a divisor of K, wherein the first addition may be an addition of the first input and a sign inverted second input, the second addition may be an addition of a result of the first addition and the divisor of K, and the multiplexer may receive inputs of the result of the first addition and a result of the second addition and output the result of the second addition when the result of the first addition is a negative number and output the result of the first addition when the result of the first addition is a positive number.

Specific matters of other embodiments are included in the detailed description and drawings.

[Advantageous Effects]

The present invention has an effect of reducing the time spent for generating total indexes by generating indexes for a plurality of bits in parallel.

Also, the present invention has an effect of improving the resource efficiency and the performance in the hardware implementation by calculating indexes for following bits through the use of an index calculated for a predetermined bit without the use of a multiplier and a divider.

[Description of Drawings]

The foregoing and other objects, features and advantages of the present invention will become more apparent from the following detailed description when taken in conjunction with the accompanying drawings in which:

FIG. 1 is a diagram illustrating the apparatus for generating the internal interleaver index of the conventional turbo encoder.
FIG. 2 is a diagram illustrating an interleaver index generating apparatus according to an embodiment of the present invention.
FIG. 3 is a diagram illustrating a modular circuit according to an embodiment of the present invention.
FIG. 4 is a diagram illustrating a modular circuit according to another embodiment of the present invention.
FIG. 5 is a diagram illustrating an interleaver index generating apparatus according to another embodiment of the present invention.
FIG. 6 is a diagram illustrating a subsequent-index generator according to an embodiment of the present invention.
FIG. 7 is a flowchart illustrating an interleaver index generating method according to an embodiment of the present invention.

[Mode for Invention]

The above and other objects, features and advantages of the present invention will be more apparent from the following detailed description taken in conjunction with the accompanying drawings. FIG. 2 is a diagram illustrating an interleaver index generating apparatus 200 according to an embodiment of the present invention. Referring to FIG. 2, the interleaver index generating apparatus 200 includes a main processor 210 and eight index operators 220. Each of the index operators 220 includes a first storage apparatus 221, a second storage apparatus 222, and a subsequent-index generator 223.

The interleaver index generating apparatus 200 according to the embodiment of the present invention generates indexes of the interleaver for input data.

The indexes of the interleaver correspond to $\Pi(i)$ satisfying the an equation of $\Pi(i)=(f_1{*}i+f_2{*}i^2)\mathrm{mod}K$, and $f_1$ and $f_2$ derived from the input data and values of i according to an order of bits are used in the above equation.

For example, parameters used in the above equation are as defined in the below table.

[Table 1]

| i | Ki | f1 | f2 | i | Ki | f1 | f2 |
|---|-----|-----|-----|-----|------|-----|-----|
| 1 | 40 | 3 | 10 | 95 | 1120 | 67 | 140 |
| 2 | 48 | 7 | 12 | 96 | 1152 | 35 | 72 |
| 3 | 56 | 19 | 42 | 97 | 1184 | 19 | 74 |
| 4 | 64 | 7 | 16 | 98 | 1216 | 39 | 76 |
| 5 | 72 | 7 | 18 | 99 | 1248 | 19 | 78 |
| 6 | 80 | 11 | 20 | 100 | 1280 | 199 | 240 |
| 7 | 88 | 5 | 22 | 101 | 1372 | 21 | 82 |
| 8 | 96 | 11 | 24 | 102 | 1344 | 211 | 252 |
| 9 | 104 | 7 | 26 | 103 | 1376 | 21 | 86 |
| 10 | 112 | 41 | 84 | 104 | 1408 | 43 | 88 |
| 11 | 120 | 103 | 90 | 105 | 1440 | 149 | 60 |

(continued)

| i | Ki | f1 | f2 | i | Ki | f1 | f2 |
|---|---|---|---|---|---|---|---|
| 12 | 128 | 15 | 32 | 106 | 1472 | 45 | 92 |
| 13 | 136 | 9 | 34 | 107 | 1504 | 49 | 846 |
| 14 | 144 | 17 | 108 | 108 | 1536 | 71 | 48 |
| 15 | 152 | 9 | 38 | 109 | 1568 | 13 | 28 |
| 16 | 160 | 21 | 120 | 110 | 1600 | 17 | 80 |
| 17 | 168 | 101 | 84 | 111 | 1632 | 25 | 102 |
| 18 | 176 | 21 | 44 | 112 | 1664 | 183 | 104 |
| 19 | 184 | 57 | 46 | 113 | 1696 | 55 | 954 |
| 20 | 192 | 23 | 48 | 114 | 1728 | 127 | 96 |
| 21 | 200 | 13 | 50 | 115 | 1760 | 27 | 110 |
| 22 | 208 | 27 | 52 | 116 | 1792 | 29 | 112 |
| 23 | 216 | 11 | 36 | 117 | 1824 | 29 | 114 |
| 24 | 224 | 27 | 56 | 118 | 1856 | 57 | 116 |
| 25 | 232 | 85 | 58 | 119 | 1888 | 45 | 354 |
| 26 | 240 | 29 | 60 | 120 | 1920 | 31 | 120 |
| 27 | 248 | 33 | 62 | 121 | 1952 | 59 | 610 |
| 28 | 256 | 15 | 32 | 122 | 1984 | 185 | 124 |
| 29 | 264 | 17 | 198 | 123 | 2016 | 113 | 420 |
| 30 | 272 | 33 | 68 | 124 | 2048 | 31 | 64 |
| 31 | 280 | 103 | 210 | 125 | 2112 | 17 | 66 |
| 32 | 288 | 19 | 36 | 126 | 2176 | 171 | 136 |
| 33 | 296 | 19 | 74 | 127 | 2240 | 209 | 420 |
| 34 | 304 | 37 | 76 | 128 | 2304 | 253 | 216 |
| 35 | 312 | 19 | 78 | 129 | 2368 | 367 | 444 |
| 36 | 320 | 21 | 120 | 130 | 2432 | 265 | 456 |
| 37 | 328 | 21 | 82 | 131 | 2496 | 181 | 468 |
| 38 | 336 | 115 | 84 | 132 | 2560 | 39 | 80 |
| 39 | 344 | 193 | 86 | 133 | 2624 | 27 | 164 |
| 40 | 352 | 21 | 44 | 134 | 2688 | 127 | 504 |
| 41 | 360 | 133 | 90 | 135 | 2752 | 143 | 172 |
| 42 | 368 | 81 | 46 | 136 | 2816 | 43 | 88 |
| 43 | 376 | 45 | 94 | 137 | 2880 | 29 | 300 |
| 44 | 384 | 23 | 48 | 138 | 2944 | 45 | 92 |
| 45 | 392 | 243 | 98 | 139 | 3008 | 157 | 188 |
| 46 | 400 | 151 | 40 | 140 | 3072 | 47 | 96 |
| 47 | 408 | 155 | 102 | 141 | 3136 | 13 | 28 |
| 48 | 416 | 25 | 52 | 142 | 3200 | 111 | 240 |
| 49 | 424 | 51 | 106 | 143 | 3264 | 443 | 204 |

(continued)

| i | Ki | f1 | f2 | i | Ki | f1 | f2 |
|---|---|---|---|---|---|---|---|
| 50 | 432 | 47 | 72 | 144 | 3328 | 51 | 104 |
| 51 | 440 | 91 | 110 | 145 | 3392 | 51 | 212 |
| 52 | 448 | 29 | 168 | 146 | 3456 | 451 | 192 |
| 53 | 456 | 29 | 114 | 147 | 3520 | 257 | 220 |
| 54 | 464 | 247 | 58 | 148 | 3584 | 57 | 336 |
| 55 | 472 | 29 | 118 | 149 | 3648 | 313 | 228 |
| 56 | 480 | 89 | 180 | 150 | 3712 | 271 | 232 |
| 57 | 488 | 91 | 122 | 151 | 3776 | 179 | 236 |
| 58 | 496 | 157 | 62 | 152 | 3840 | 331 | 120 |
| 59 | 504 | 55 | 84 | 153 | 3904 | 363 | 244 |
| 60 | 512 | 31 | 64 | 154 | 3968 | 375 | 248 |
| 61 | 528 | 17 | 66 | 155 | 4032 | 127 | 168 |
| 62 | 544 | 35 | 68 | 156 | 4096 | 31 | 64 |
| 63 | 560 | 227 | 420 | 157 | 4160 | 33 | 130 |
| 64 | 576 | 65 | 96 | 158 | 4224 | 43 | 264 |
| 65 | 592 | 19 | 74 | 159 | 4288 | 33 | 134 |
| 66 | 608 | 37 | 76 | 160 | 4352 | 477 | 408 |
| 67 | 624 | 41 | 234 | 161 | 4416 | 35 | 138 |
| 68 | 640 | 39 | 80 | 162 | 4480 | 233 | 280 |
| 69 | 656 | 185 | 82 | 163 | 4544 | 357 | 142 |
| 70 | 672 | 43 | 252 | 164 | 4608 | 337 | 480 |
| 71 | 688 | 21 | 86 | 165 | 4672 | 37 | 146 |
| 72 | 704 | 155 | 44 | 166 | 4736 | 71 | 444 |
| 73 | 720 | 79 | 120 | 167 | 4800 | 71 | 120 |
| 74 | 736 | 139 | 92 | 168 | 4864 | 37 | 152 |
| 75 | 752 | 23 | 94 | 169 | 4928 | 39 | 462 |
| 76 | 768 | 217 | 48 | 170 | 4992 | 127 | 234 |
| 77 | 784 | 25 | 98 | 171 | 5056 | 39 | 158 |
| 78 | 800 | 17 | 80 | 172 | 5120 | 39 | 80 |
| 79 | 816 | 127 | 102 | 173 | 5184 | 31 | 96 |
| 80 | 832 | 25 | 52 | 174 | 5248 | 113 | 902 |
| 81 | 848 | 239 | 106 | 175 | 5312 | 41 | 166 |
| 82 | 864 | 17 | 48 | 176 | 5376 | 251 | 336 |
| 83 | 880 | 137 | 110 | 177 | 5440 | 43 | 170 |
| 84 | 896 | 215 | 112 | 178 | 5504 | 21 | 86 |
| 85 | 912 | 29 | 114 | 179 | 5568 | 43 | 174 |
| 86 | 928 | 15 | 58 | 180 | 5632 | 45 | 176 |
| 87 | 944 | 147 | 118 | 181 | 5696 | 45 | 178 |

(continued)

| i | Ki | f1 | f2 | i | Ki | f1 | f2 |
|---|-----|-----|-----|-----|------|-----|-----|
| 88 | 960 | 29 | 60 | 182 | 5760 | 161 | 120 |
| 89 | 976 | 59 | 122 | 183 | 5824 | 89 | 182 |
| 90 | 992 | 65 | 124 | 184 | 5888 | 323 | 184 |
| 91 | 1008 | 55 | 84 | 185 | 5952 | 47 | 186 |
| 92 | 1024 | 31 | 64 | 186 | 6016 | 23 | 94 |
| 93 | 1056 | 17 | 66 | 187 | 6080 | 47 | 190 |
| 94 | 1088 | 171 | 204 | 188 | 6144 | 263 | 480 |

That is, indexes generated from a first example in Table 1, in which is $K_i$=40, $f_1$=3, and $f_2$=10, are sequentially 0, 13, 6, 19, 12, 25, 18, 31, 24, 37, 30, 3, 36, 9, 2, 15, 8, 21, 14, 27, 20, 33, 26, 39, 32, 5, 38, 11, 4, 17, 10, 23, 16, 29, 22, 35, 28, 1, 34, 7.

The main processor 210 calculates an index for a predetermined bit of input data.

According to an exemplary embodiment of the present invention, the main processor 210 calculates an index for a predetermined bit of input data by using the difference between index values.

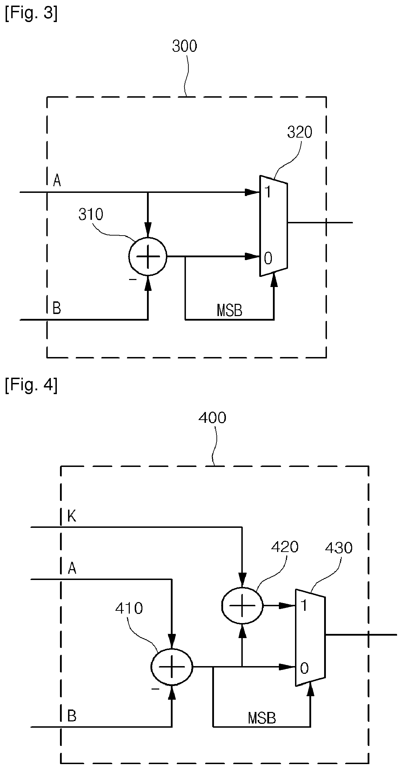

FIG. 3 is a diagram illustrating a modular circuit 300 according to an embodiment of the present invention. Referring to FIG. 3, the modular circuit 300 according to the embodiment of the present invention includes an adder 310 and a multiplexer 320.

A modular operation corresponds to an operation for outputting a remainder generated by multiplying a dividend by a divisor.

The adder 310 receives inputs of the dividend and the divisor and adds the dividend and a sign inverted divisor. That is, the adder 310 derives a value generated by subtracting the divisor from the dividend.

The multiplexer 320 receives inputs of a result of the addition and the dividend. The multiplexer outputs the dividend when the result of the addition is a negative number and outputs the result of the addition when the result of the addition is a positive number.

According to another exemplary embodiment of the present invention, the index for the predetermined bit is operated through the modular operation using the modular circuit 300 according to an embodiment of the present invention.

That is, although the main processor 210 does not provide the index operator 220 with the index value for the predetermined bit, the index for the predetermined bit may be operated through the modular circuit 300 according to the embodiment of the present invention and then the operated index may be provided to the index operator 220.

The modular circuit 300 according to the embodiment of the present invention has an effect of replacing the multiplier and the divider with the multiplexer and the adder, which are less important resources in an aspect of the hardware implementation.

The modular operation has an effect of managing efficient hardware resources through the replacement of the divider with the adder and the multiplexer, which are circuit elements having less importance in an aspect of the hardware implementation.

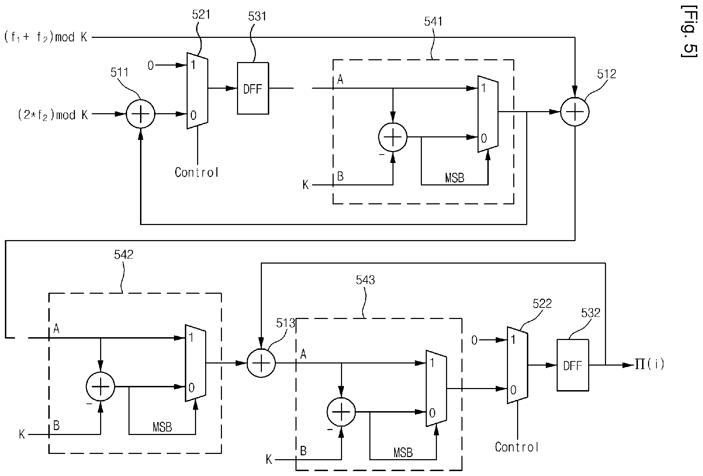

FIG. 5 is a diagram illustrating an interleaver index generating apparatus 500 according to another embodiment of the present invention. Referring to FIG. 5, the interleaver index generating apparatus 500 according to another embodiment of the present invention includes three adders 511, 512, and 513, two multiplexers 521 and 522, two D-flip flops 531 and 532, and three modular operators 541, 542, and 543.

The interleaver index generating apparatus 500 according to another embodiment of the present invention receives inputs of $(f_1+f_2)$modK, $(2*f_2)$modK, and K and sequentially outputs II(i).

The interleaver index generating apparatus 500 according to another embodiment of the present invention derives II(I) by using an equation of $\Pi(i+1)-\Pi(i)=(f_1+f_2+2*f_2*i)$mod$K$.

For easier understanding, the above equation is organized as follows.

$$\prod(i+1) - \prod(i) = \{f_1{}^*(i+1) + f_2{}^*(i+1)^2 - (f_1{}^*i + f_2{}^*i^2)\} \bmod K$$

$$= \{\qquad f_1 * i + f_1 + f_2 * i^2 + 2 * f_2 * i + f_2 -$$

$$(f_1{}^*i + f_2{}^*i^2)\} \bmod K$$

$$= (f_1 + f_2 + 2 * f_2 * i) \bmod K$$

That is, the difference between a current index value and a subsequent index value is calculated by adding $f_1 + f_2$ and double of the value of $f_2$ multiplied by i, so that II (i) derived by the interleaver index generating apparatus 500 according to another embodiment of the present invention satisfies $\Pi(i) = (f_1{}^*i + f_2{}^*i^2) \bmod K$.

The first adder 511 receives an input of $(2^*f_2) \bmod K$ and outputs a result value of the addition of $(2^*f_2) \bmod K$ and an output value of the first modular operator 541. In an initial performance, it is not possible to receive the output value of the first modular operator 541 so the output value of the first adder 511 is in an unknown state.

The first multiplexer 521 receives inputs of the output value of the first adder 511 and "0", outputs "0" in generating a first index by a control signal, and then outputs the output value of the first adder 511 after that. The reason why "0" is generated as the first index is that a first index of the interleaver should be "0" and also a first output value of the first adder 511 is in an unknown state.

The first D-flip flop 531 receives an input of the output value of the first multiplexer 521 and temporarily stores the output value of the first multiplexer 521 because a loop-back is performed in which an output value of the first modular operator 541 is used in the first adder 511.

Further, the first D-flip flop 531 enables the accumulation of $2^*f_2$ according to an increase of i in $\Pi(i+1)-\Pi(i) = (f_1 + f_2 + 2^*f_2{}^*i) \bmod K$ to be performed using the loop-back.

The first modular operator 541 receives inputs of K and the output value of the first D-flip flop 531 and performs the modular operation described through FIG. 3.

The second adder 512 outputs a result of the addition of the output value of the first modular operator 541 and $(f_1 + f_2) \bmod K$.

The second modular operator 542 receives inputs of K and the output value of the second adder 512 and performs the modular operation described through FIG. 3.

The third adder 513 receives an input of the output value of the second modular operator 542 and outputs a result of the addition of the output value of the second modular operator 542 and the output value of the second D-flip flop 532. In an initial performance, it is not possible to receive the output value of the second D-flip flop 532 so the output value is in an unknown state.

The third modular operator 543 receives inputs of K and the output value of the third adder 513 and performs the modular operation described through FIG. 3.

The second multiplexer 522 receives inputs of the output value of the third modular operator 543 and "0", outputs "0" in generating a first index by a control signal, and then outputs the output value of the third adder 543 after that. The reason why "0" is generated as the first index is that a first index of the interleaver should be "0" and also a first output value of the third adder 543 is in an unknown state.

The second D-flip flop 532 receives an input of the output value of the second multiplexer 522 and temporarily stores the output value of the second multiplexer 522 because a loop-back is performed in which the output value of the second multiplexer 522 is used in the third adder 513.

Referring back to FIG. 3, it is preferable that the interleaver index generating apparatus 500 may be used for deriving an index value for a predetermined bit provided to the index operator 220 from the main processor 210. That is, when the main processor 210 does not provide the index operator 220 with the index value for the predetermined bit, the index for the predetermined bit is operated using the interleaver index generating apparatus 500 and then the operated index may be provided to the index operator 220.

According to another exemplary embodiment of the present invention, the main processor 210 calculates $(128^*f_2) \bmod K$ and indexes for $i^{th}$ to $i+15^{th}$ bits (here, i is an integer equal to or larger than 0) of input data and transfers them to the index operator 220. The main processor 210 transfers K, $(128^*f_2) \bmod K$, and index values for $i+j^{th}$ and $(i+j)+8^{th}$ bits (here, $0 \le j \le 7$) of input data to each of the eight index operators 220.

The index operator 220 calculates indexes for bits after bits calculated by the main processor 210 in parallel by using the values transferred from the main processor 210 and derives a plurality of indexes.

According to another exemplary embodiment of the present invention, the index operator 220 receives index values for $i+j^{th}$ and $(i+j)+8^{th}$ bits (here, $0 \le j \le 7$) of input data from the main processor 210 and calculates an index for an $(i+j)+16^{th}$ bit by using the difference between the indexes.

In FIG. 2, the index value for the i+j$^{th}$ bit of the input data is represented as II(i$_0$), the index value for the (i+j)+8$^{th}$ bit of the input data is represented as II(i$_1$). After that, i is represented as i$_m$ in which i is increased by 8. That is, i$_{m+1}$ is equal to i$_m$+8 and i$_{m+2}$ is equal to i$_m$+16.

*84 According to another exemplary embodiment of the present invention, the index operator 220 receives (128*f$_2$) modK and index values for i+j$^{th}$ and (i+j)+8$^{th}$ bits (here, 0≤j≤7) of input data from the main processor 220 and calculates an index for an (i+j)+16$^{th}$ bit by using an equation of

$$\Pi(i+j+16) = (2*\Pi(i+j+8) - \Pi(i+j) + 128*f_2) \bmod K .$$

The index of the interleaver has the following characteristics.

1. All Ki is a multiple of eight.
2. A first index is always "0".
3. A remainder generated by dividing a generated index by eight has a form of being repeated every eight times.
4. When first eight indexes and second eight indexes have been generated, all indexes from third eight indexes may be generated in the unit of eights.

Accordingly, the index of the interleaver satisfies the following equation.

$$\Pi(i+j+16) = (2*\Pi(i+j+8) - \Pi(i+j) + 128*f_2) \bmod K$$

For easier understanding, the above equation is organized as follows.

$$\Pi(i+8) = \{f_1*(i+8) + f_2*(i+8)^2\} \bmod K$$

$$= \{f_1*i + 8*f_1 + f_2*i^2 + 16*f_2*i + 64*f_2\} \bmod K$$

The above equation is organized as follows after adding II(i) to and then subtracting II(i) from the above equation.

$$\Pi(i+8) = \{f_1*i + 8*f_1 + f_2*i^2 + 16*f_2*i + 64*f + (f_1*i + f_2*i^2) - (f_1*i + f_2*i^2)\} \bmod K$$

$$=$$

$$\{f_1*i + f_1*i + f_2*i^2 + f_2*i^2 + 8*f_1 + 16*f_2*i + 64*f_2 - (f_1*i + f_2*i^2)\} \bmod K$$

$$= \{2*(f_1*i + f_2*i^2) - (f_1*i - 8*f_1) - (f_2*i^2 - 16*f_2*i - 64*f_2\} \bmod K$$

The above equation is organized as follows after adding 128*f$_2$ to and then subtracting 128*f$_2$ from the above equation.

$$\prod(i+8) = \{2*(f_1*i+f_2*i^2)+128*f_2-128*f_2-(f_1*i-8*f_1)$$

$$-(f_2*i^2-16*f_2*i-64*f_2\} \bmod K$$

$$=\{2*(f_1*i+f_2*i^2)-(f_1*i-8*f_1)-(f_2*i^2-16*f_2*i+64*f_2)+128*f_2\}\bmod K$$

$$=\{2*(f_1*i+f_2*i^2)-f_1*(i-8)-f_2*(i-8)^2+128*f_2\} \bmod K$$

$$=\{2*\prod(i)-\prod(i-8)+128*f_2\} \bmod K$$

It is preferable that the index generator 220 includes the first storage apparatus 221, the second storage apparatus 222, and the subsequent-index generator 223. The index generator 220 receives $\Pi(i_0)$, $\Pi(i_1)$, $(128*f_2)\bmod K$, and K from the main processor 210, calculates indexes after $\text{II}(i_0)$, and enables outputs to be sequentially output from $\text{II}(i_0)$.

The first storage apparatus 221 receives $\text{II}(i_0)$ from the main processor 210 and stores the received $\text{II}(i_0)$ at first. After that, the first storage apparatus 221 sequentially receives $\text{II}(i_{m+1})$ stored in the second storage apparatus 222 and stores the received $\text{II}(i_{m+1})$. Further, the first storage apparatus 221 transfers stored values to the subsequent-index generator 223. And then the first storage apparatus 221 sequentially outputs stored values as output values of the index operator 220.

For example, the first storage apparatus 221 stores and outputs first $\text{II}(i_0)$, the second storage apparatus 222 receives the first stored $\text{II}(i_1)$ and then stores and outputs the received $\text{II}(i_1)$, and then the second storage apparatus 222 receives $\text{II}(i_2)$ output through $\text{II}(i_0)$ and $\text{II}(i_1)$ by the subsequent-index generator 223 and then stores and outputs the received $\text{II}(i_2)$. That is, the first storage apparatus 221 sequentially stores values from $\text{II}(i_0)$ to $\text{II}(i_m)$, transfers them to the subsequent-index generator 223, and outputs them as output values of the index operator 220.

The second storage apparatus 222 receives $\text{II}(i_1)$ from the main processor 210 and stores the received $\text{II}(i_1)$. After that, the second storage apparatus 222 receives $\text{II}(i_{m+2})$, which is an output value of the subsequent-index generator 223, and stores the received $\text{II}(i_{m+2})$. Further, the second storage apparatus 222 transfers stored values to the subsequent-index generator 223 and the first storage apparatus 221. That is, the second storage apparatus 222 sequentially stores values from $\text{II}(i_1)$ to $\text{II}(i_{m+1})$ and transfers them to the subsequent-index generator 223 and the first storage apparatus 221.

The subsequent-index generator 223 calculates $\text{II}(i_{m+2})$ by using K, $\text{II}(i_m)$ and $\text{II}(i_{m+1})$ received from the first storage apparatus 221 and the second storage apparatus 223, and $(128*f_2)\bmod K$ received from the main processor 210. It is preferable that the subsequent-index generator 223 calculates $\text{II}(i_{m+2})$ by using the following equation $\Pi(i_{m+2})=(2*\Pi(i_{m+1})-\Pi(i_m)+128*f_2)\bmod K$. Further, the subsequent-index generator 223 transfers the calculated $\text{II}(i_{m+2})$ to the second storage apparatus 222.

It is preferable that there are eight index operators 220 and the eight index operators receive $(\Pi(0), \Pi(8))$, $(\Pi(1), \Pi(9))$, $(\Pi(2), \Pi(10))$, $(\Pi(3), \Pi(11))$, $(\Pi(4), \Pi(12))$, $(\Pi(5), \Pi(13))$, $(\Pi(6), \Pi(14))$, $(\Pi(7), \Pi(15))$ to output $\Pi(n*8)$, $\Pi(n*8+1)$, $\Pi(n*8+2)$, $\Pi(n*8+3)$, $\Pi(n*8+4)$, $\Pi(n*8+5)$, $\Pi(n*8+6)$, $\Pi(n*8+7)$, respectively (n is an integer equal to or larger than 2 and equal to or smaller than (K/8-1)).

FIG. 4 is a diagram illustrating a modular circuit 400 according to another embodiment of the present invention. Referring to FIG. 4, the modular circuit 400 according to another embodiment of the present invention includes a first adder 410, a second adder 420, and a multiplexer 430 and receives a first input, a second input, and a divisor K.

The first adder 410 adds the first input and a sign inverted second input and outputs the added value. That is, the first adder 410 subtracts the second input from the first input.

The second adder 420 adds the output value of the first adder 410 and the divisor K and outputs the added value.

The multiplexer 430 receives inputs of the output value of the first adder 410 and the output value of the second adder 420. The multiplexer outputs the output value of the first adder 410 when the output value of the first adder 410 is a positive number and outputs the output value of the second adder 420 when the output value of the first adder 410 is a negative number.

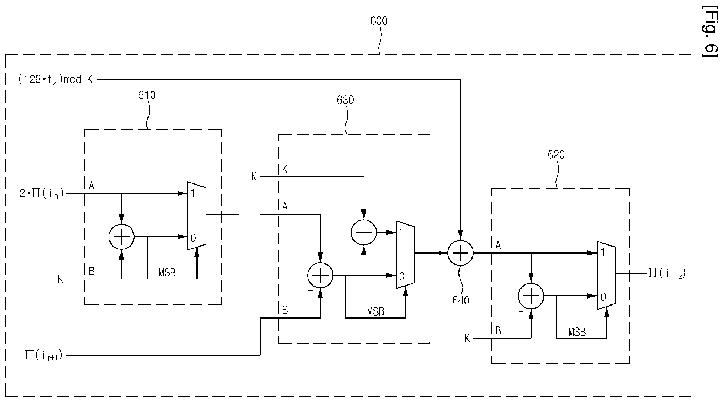

FIG. 6 is a diagram illustrating a subsequent-index generator according to an embodiment of the present invention. Referring to FIG. 6, the subsequent-index generator 600 according to the embodiment of the present invention includes two modular operators 610 and 620 described through FIG. 3, one modular operator 630 described through FIG. 4, and one adder 640. The subsequent-index generator 600 receives inputs of $(128*f_2)$modK, $2*II(i_m)$, K, and $II(i_{m+1})$ and outputs $II(i_{m+2})$.

It is preferable that $2*II(i_m)$ received by the subsequent-index generator 600 according to the embodiment of the present invention may be operated by applying a bit shift through a reception of $II(i_m)$ without the use of multiplier.

The first modular operator 610 receives inputs of $2*II(i_m)$ and K, and performs the modular operation described in FIG. 3.

The second modular operator 630 receives inputs of the output value of the first modular operator 610, $II(i_{m+1})$, and K, and performs the modular operation described in FIG. 4.

The adder 640 adds the output value of the second modular operator 630 and $(128*f_2)$modK and outputs the added value.

The third modular operator 620 receives inputs of the output value of the adder 640 and K, and performs the modular operation described in FIG. 3.

The output value of the third modular operator 620 corresponds to the output value of the subsequent-index generator 600, which is $II(i_{m+2})$.

It is preferable that the aforementioned multiplexer can determine whether an input value is a negative number or a positive number by using a most significant bit value.

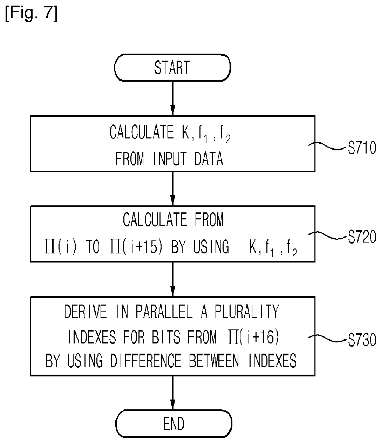

FIG. 7 is a flowchart illustrating an interleaver index generating method according to an embodiment of the present invention. Referring to FIG. 7, the interleaver index generating method according to the embodiment of the present invention includes calculating K, $f_1$, and $f_2$ from input data in step S710, calculating values of indexes from $II(i)$ to $II(i+15)$ for $i^{th}$ to $i+15^{th}$ bits, which are predetermined bits of the input data, by using the K, $f_1$, and $f_2$ calculated in step S710 in step S720, and calculating in parallel values from $II(i+16)$ by using the values from $II(i)$ to $II(i+15)$ calculated in step S720 and differences between the index values in step S730.

In step S710, the index generating apparatus calculates K, $f_1$, and $f_2$ from input data.

In step S720, the index generating apparatus calculates indexes for predetermined bits of the input data by using K, $f_1$, and $f_2$ calculated in step S710.

According to an exemplary embodiment of the present invention, the index generating apparatus calculates differences between index values for bits by using the following equation $\Pi(i+1)-\Pi(i)=(f_1+f_2+2*f_2*i)$mod$K$, and calculates indexes for bits from an $i+1^{th}$ bit by using the calculated differences in step S720.

According to an exemplary embodiment of the present invention, the modular operation is performed using an addition and the multiplexer. The addition refers to an addition of the dividend and the sign inverted divisor of the modular operation, and the multiplexer receives inputs of a result of the addition and the dividend. The multiplexer outputs the dividend when the result of the addition is a negative number and outputs the result of the addition when the result of the addition is a positive number.

According to another exemplary embodiment of the present invention, the index generating apparatus calculates indexes for $i^{th}$ to $i+15^{th}$ bits (here, i is an integer equal to or larger than 0) of input data and $(128*f_2)$modK in step S720.

In step S730, the index generating apparatus calculates in parallel indexes for bits after the bit calculated using the index values calculated in step S720.

According to an exemplary embodiment of the present invention, the index generating apparatus calculates indexes for bits from an $i+16^{th}$ bit by using the following equation $\Pi(i+j+16)=(2*\Pi(i+j+8)-\Pi(i+j)+128*f_2)$mod$K$ (here, $0{\leq}j{\leq}7$) in step S730.

According to another exemplary embodiment of the present invention, the index generating apparatus receives a first input, a second input, and an input of the divisor K, and uses the modular operation performed using a first addition, a second addition, and the multiplexer in step S730. Each of the operations used in the modular operation is as follows.

The first addition refers to an addition of the first input and a sign inverted second input, and the second addition refers to an addition of a result of the first addition and the divisor K. The multiplexer receives inputs of the result of the first addition and a result of the second addition.

** Reference Numerals

200: Interleaver Index Generating Apparatus
210: Main Processor          220: Index Operator
221: First Storage Apparatus   222: Second Storage Apparatus
223: Subsequent-Index Generator

**Claims**

1. An apparatus for generating indexes of a quadratic polynominal permutation interleaving rule according to $\Pi(i) = (f_1 * i + f_2 * i^2)$ mod K, wherein i = 0, 1, 2, ..., K-1, i denotes bit indexes of an input stream, $\Pi(i)$ denotes bit indexes of an output stream, K denotes a size of input data, and $f_1$ and $f_2$ denote coefficients calculated from K, the apparatus **characterized by** comprising:

   a main processor (210) being adapated to calculate bit indexes $\Pi(0)$ to $\Pi(15)$ of the output stream for a first sixteen indexes of the input stream, and for transferring K, a result of $(128 * f_2)$ mod K and the bit indexes $\Pi(j)$ and $\Pi(j+8)$ where $0 \leq j \leq 7$ to one of eight index operators (220); and
   the eight index operators (220) being adapted to operate in parallel for calculating output index values II(n*8), II(n*8 + 1), $\Pi$(n*8 + 2), $\Pi$(n*8 + 3), $\Pi$(n*8 + 4), $\Pi$(n*8 + 5), $\Pi$(n*8 + 6), II(n*8 + 7) in parallel where $2 \leq n \leq K/8$ -1, wherein a j-th index operator of the eight index operators (220) calculates the index for an (i + j + 16)th bit using an equation of:

$$\Pi(i+j+16)=(2*\Pi(i+j+8)-\Pi(i+j)+128*f_2)\mathrm{mod}K$$

   with i being increased by eight.

2. The apparatus as claimed in claim 1, wherein the modular operation of the equation is performed using an adder (310) and a multiplexer (320).

3. The apparatus as claimed in claim 2, wherein the adder (310) adds the dividend of the modular operation and a sign inverted divisor of the modular operation, and the multiplexer (320) receives inputs of a result of the addition and the dividend, wherein the multiplexer (320) outputs the dividend when the result of the addition is a negative number and outputs a result of the adder (310) when the result of the adder (310) is a positive number.

4. The apparatus as claimed in claim 1, wherein the modular operation of the equation is performed using a first adder (410), a second adder (420), and a multiplexer (430) through receptions of a first input, a second input, and a divisor equal to K.

5. The apparatus as claimed in claim 4, wherein the first adder (410) adds the first input and a sign inverted second input, the second adder (420) adds a result of the first adder (410) and a divisor equal to K, and the multiplexer (430) receives inputs of the result of the first adder (410) and a result of the second adder (420) and outputs the result of the second adder (420) when the result of the first adder (410) is a negative number and outputs the result of the first adder (410) when the result of the first adder (410) is a positive number.

6. A method of generating indexes of a quadratic polynominal permutation interleaving rule according to $\Pi(i) = (f_1 * i + f_2 * i^2)$ mod K, wherein i = 0, 1, 2, ..., K-1, i denotes bit indexes of an input stream, $\Pi(i)$ denotes bit indexes of an output stream, K denotes a size of input data, and $f_1$ and $f_2$ denote coefficients calculated from K, the method **characterized by** comprising the steps of:

   (a) calculating bit indexes $\Pi(0)$ to $\Pi(15)$ of the output stream for a first sixteen indexes of the input stream;
   (b) transferring K, a result of $(128 * f_2)$ mod K and the bit indexes $\Pi(j)$ and $\Pi(j+8)$ where $0 \leq j \leq 7$ to one of eight index operators (220) being adapted to operate in parallel;
   (c) calculating, by the eight index operators (220), output index values $\Pi$(n*8), $\Pi$(n*8 + 1), $\Pi$(n*8 + 2), II(n*8 + 3), $\Pi$(n*8 + 4), II(n*8 + 5), II(n*8 + 6), $\Pi$(n*8 + 7) in parallel where $2 \leq n \leq K/8$ -1, wherein the index for an (i + j + 16)th bit is calculated by a j-th index operator of the eight index operators (220) using an equation of:

$$\Pi(i+j+16)=(2*\Pi(i+j+8)-\Pi(i+j)+128*f_2)\mathrm{mod}K$$

   with i being increased by eight.

7. The method as claimed in claim 6, wherein the modular operation of the equation is performed using an adder (310) and a multiplexer (320),

wherein the adder (310) adds the dividend and a sign inverted divisor of the modular operation, and the multiplexer (320) receives inputs of the dividend and a result of the adder (310),

wherein the multiplexer (320) outputs the dividend when the result of the adder (310) is a negative number and outputs the result of the adder (310) when the result of the adder (310) is a positive number.

8.  The method as claimed in claim 6, wherein the modular operation of the equation is performed using a first adder (410), a second adder (420), and a multiplexer (430) through receptions of a first input, a second input, and a divisor equal to K,

wherein the first adder (410) adds the first input and a sign inverted second input, the second adder (420) adds a result of the first addition and K, and the multiplexer (430) receives inputs of the result of the first adder (410) and a result of the second adder (420) and outputs the result of the second adder (420) when the result of the first adder (410) is a negative number and outputs the result of the first adder (410) when the result of the first adder (410) is a positive number.

**Patentansprüche**

1.  Vorrichtung zum Erzeugen von Indizes einer quadratischen polynomischen Permutationsverschachtelungsregel gemäß $\Pi(i) = (f_1{*}i + f_2{*}i^2)$ mod K, wobei i = 0, 1, 2, ...., K-1, wobei i Bitindizes eines Eingangsstroms bezeichnet, $\Pi(i)$ Bitindizes eines Ausgangsstroms bezeichnet, K eine Größe von Eingabedaten bezeichnet und $f_1$ und $f_2$ aus K berechnete Koeffizienten bezeichnen, **dadurch gekennzeichnet, dass** die Vorrichtung umfasst:

    einen Hauptprozessor (210), der angepasst ist, um Bitindizes $\Pi(0)$ bis $\Pi(15)$ des Ausgangsstroms für die ersten sechzehn Indizes des Eingangsstroms zu berechnen, und um K, ein Ergebnis von $(128{*}f_2)$ mod K und der Bitindizes $\Pi(j)$ und $\Pi(j+8)$, wobei $0 \leq j \leq 7$, zu einem von acht Indexoperatoren (220) zu übertragen; und wobei die acht Indexoperatoren (220) zum parallelen Betrieb zum parallelen Berechnen von Ausgabeindexwerten $\Pi(n{*}8)$, $\Pi(n{*}8 + 1)$, $\Pi(n{*}8 + 2)$, $\Pi(n{*}8 + 3)$, $\Pi(n{*}8 + 4)$, $\Pi(n{*}8 + 5)$, $\Pi(n{*}8 + 6)$ $\Pi(n{*}8 + 7)$, wobei $2 \leq n \leq K/8 -1$, wobei ein j-ter Indexoperator der acht Indexoperatoren (220) den Index für ein (i + j + 16) tes Bit unter Verwendung einer Gleichung berechnet:

    $$\Pi(i+j+16)=(2{*}\Pi(i+j+8)-\Pi(i+j)+128{*}f_2) \bmod K$$

    wobei 1 um acht erhöht wird.

2.  Vorrichtung gemäß Anspruch 1, wobei die modulare Operation der Gleichung unter Verwendung eines Addierers (310) und eines Multiplexers (320) durchgeführt wird.

3.  Vorrichtung gemäß Anspruch 2, wobei der Addierer (310) den Dividend der modularen Operation und einen vorzeicheninvertierten Divisor der modularen Operation hinzufügt, und der Multiplexer (320) Eingaben von einem Ergebnis der Addition und des Dividends erhält, wobei der Multiplexer (320) den Dividend ausgibt, wenn das Ergebnis der Addition eine negative Zahl ist und ein Ergebnis des Addierers (310) ausgibt, wenn das Ergebnis des Addierers (310) eine positive Zahl ist.

4.  Vorrichtung nach Anspruch 1, wobei die modulare Operation der Gleichung unter Verwendung eines ersten Addierers (410), eines zweiten Addierers (420) und eines Multiplexers (430) mittels Empfangen einer ersten Eingabe, einer zweiten Eingabe und eines Divisors gleich K durchgeführt wird.

5.  Vorrichtung gemäß Anspruch 4, wobei der erste Addierer (410) die erste Eingabe und eine vorzeicheninvertierte zweite Eingabe hinzufügt, wobei der zweite Addierer (420) ein Ergebnis des ersten Addierers (410) und einen Divisor gleich K hinzufügt, und der Multiplexer (430) die Eingabe des Ergebnisses des ersten Addierers (410) und eines Ergebnisses des zweiten Addierers (420) empfängt und das Ergebnis des zweiten Addierers (420) ausgibt, wenn das Ergebnis des ersten Addierers (410) eine negative Zahl ist und das Ergebnis des ersten Addierers (410) ausgibt, wenn das Ergebnis des ersten Addierers (410) eine positive Zahl ist.

6.  Verfahren zum Erzeugen von Indizes einer quadratischen polynomischen Permutationsverschachtelungsregel gemäß $\Pi(i) = (f_1{*}i + f_2{*}i^2)$ mod K, wobei i = 0, 1, 2, ...., K-1, wobei i Bitindizes eines Eingangsstroms bezeichnet, $\Pi(i)$

Bitindizes eines Ausgangsstroms bezeichnet, K eine Größe von Eingabedaten bezeichnet und $f_1$ und $f_2$ aus K berechnete Koeffizienten bezeichnen, **dadurch gekennzeichnet ist, dass** das Verfahren die Schritte umfasst:

(a) Berechnen der Bitindizes $\Pi(0)$ bis $\Pi(15)$ des Ausgangsstroms für die ersten sechzehn Indizes des Eingangsstroms;

(b) Übertragen von K, einem Ergebnis von $(128*f_2)$ mod K und den Bitindizes $\Pi(j)$ und $\Pi(j+8)$, wobei $0 \leq j \leq 7$, zu einem von acht Indexoperatoren (220), die für den Parallelbetrieb ausgebildet sind;

(c) paralleles Berechnen, mittels der acht Indexoperatoren (220) der Ausgabeindexwerte $\Pi(n*8)$, $\Pi(n*8 + 1)$, $\Pi(n*8 + 2)$, $\Pi(n*8 + 3)$, $\Pi(n*8 + 4)$, $\Pi(n*8 + 5)$, $\Pi(n*8 + 5)$, $\Pi(n*8 + 6)$ $\Pi)(n*8 + 7)$, wobei $2 \leq n \leq K/8 -1$, wobei der Index für ein $(i + j + 16)$tes Bit von einem j-ten Indexoperator der acht Indexoperatoren (220) unter Verwendung einer Gleichung von: $\Pi(i+j+16)=(2*\Pi(i+j+8)-\Pi(i+j)+128*f_2)\mathrm{mod}K$, wobei i um acht erhöht wurde.

7. Verfahren gemäß Anspruch 6, wobei die modulare Operation der Gleichung unter Verwendung eines Addierers (310) und eines Multiplexers (320) durchgeführt wird,

wobei der Addierer (310) den Dividend und einen vorzeicheninvertierten Teiler des modularen Betriebs hinzufügt, und der Multiplexer (320) Eingaben des Dividends und ein Ergebnis des Addierers (310) erhält,

wobei der Multiplexer (320) den Dividend ausgibt, wenn das Ergebnis des Addierers (310) eine negative Zahl ist, und das Ergebnis des Addierers (310) ausgibt, wenn das Ergebnis des Addierers (310) eine positive Zahl ist.

8. Verfahren gemäß Anspruch 6, wobei die modulare Operation der Gleichung unter Verwendung eines ersten Addierers (410), eines zweiten Addierers (420) und eines Multiplexers (430) durch Empfangen einer ersten Eingabe, einer zweiten Eingabe und eines Divisors gleich K durchgeführt wird,

wobei der erste Addierer (410) die erste Eingabe und eine vorzeicheninvertierte zweite Eingabe hinzufügt, wobei der zweite Addierer (420) ein Ergebnis der ersten Addition und K hinzufügt, und der Multiplexer (430) Eingaben des Ergebnisses des ersten Addierers (410) und ein Ergebnis des zweiten Addierers (420) erhält und das Ergebnis des zweiten Addierers (420) ausgibt, wenn das Ergebnis des ersten Addierers (410) eine negative Zahl ist, und das Ergebnis des ersten Addierers (410) ausgibt, wenn das Ergebnis des ersten Addierers (410) eine positive Zahl ist.

## Revendications

1. Appareil pour générer des indices d'une règle d'entrelacement de permutation polynomiale quadratique selon $\Pi(i) = (f_1*i + f_2*i^2)$ mod K, dans lequel $i = 0, 1, 2, ..., K-1$, i désigne des indices de bit d'un flux de sortie, $\Pi(i)$ désigne des bit d'un flux de sortie, K désigne une taille de données d'entrée, et $f_1$ et $f_2$ désignent des coefficients calculés à partir de K, l'appareil étant **caractérisé en ce qu'**il comprend :

un processeur principal (210) qui est adapté pour calculer des indices de bit $\Pi(0)$ à $\Pi(15)$ du flux de sortie pour des seize premiers indices du flux d'entrée, et pour transférer K, un résultat de $(128*f_2)$ mod K et des indices de bit $\Pi(j)$ et $\Pi(j+8)$ où $0 \leq j \leq 7$, à l'un de huit opérateurs d'indice (220) ; et

les huit opérateurs d'indice (220) étant adaptés pour opérer en parallèle pour calculer des valeurs d'indice de sortie $\Pi(n*8)$, $\Pi(n*8 + 1)$, $\Pi(n*8 + 2)$, $\Pi(n*8 + 3)$, $\Pi(n*8 + 4)$, $\Pi(n*8 + 5)$, $\Pi(n*8 + 6)$, $\Pi(n*8 + 7)$, en parallèle où $2 \leq n \leq K/8 - 1$, dans lequel un j-ième opérateur d'indice des huit opérateurs d'indice (220) calcule l'indice pour un $(i + j + 16)$-ième bit en utilisant une équation suivante :

$$\Pi(i+j+16) = (2*\Pi(i+j+8) - \Pi(i+j) + 128*f_2) \bmod K$$

avec i étant augmenté de huit.

2. Appareil selon la revendication 1, dans lequel l'opération modulaire de l'équation est effectuée en utilisant un additionneur (310) et un multiplexeur (320).

3. Appareil selon la revendication 2, dans lequel l'additionneur (310) additionne le dividende de l'opération modulaire et un diviseur de signe inversé de l'opération modulaire, et le multiplexeur (320) reçoit des entrées d'un résultat de l'addition et du dividende, dans lequel le multiplexeur (320) délivre en sortie le dividende quand le résultat de l'addition est un nombre négatif et délivre en sortie un résultat de l'additionneur (310) quand le résultat de l'additionneur (310) est un nombre positif.

4. Appareil selon la revendication 1, dans lequel l'opération modulaire de l'équation est effectuée en utilisant un premier additionneur (410), un deuxième additionneur (420) et un multiplexeur (430) par le biais de réceptions d'une première entrée, d'une deuxième entrée et d'un diviseur égal à K.

5. Appareil selon la revendication 4, dans lequel le premier additionneur (410) additionne la première entrée et une deuxième entrée de signe inversé, le deuxième additionneur (420) additionne un résultat du premier additionneur (410) et un diviseur égal à K, et le multiplexeur (430) reçoit des entrées du résultat du premier additionneur (410) et d'un résultat du deuxième additionneur (420) et délivre en sortie le résultat du deuxième additionneur (420) quand le résultat du premier additionneur (410) est un nombre négatif et délivre en sortie le résultat du premier additionneur (410) quand le résultat du premier additionneur (410) est un nombre positif.

6. Procédé de génération d'indices d'une règle d'entrelacement de permutation polynomiale quadratique selon $\Pi(i) = (f_1*i + f_2*i^2) \bmod K$, dans lequel i $\pm$ 0, 1, 2, ..., K-1, i désigne des indices de bit d'un flux de sortie, $\Pi(i)$ désigne des bit d'un flux de sortie, K désigne une taille de données d'entrée, et $f_1$ et $f_2$ désignent des coefficients calculés à partir de K, le procédé étant **caractérisé en ce qu'**il comprend les étapes suivantes :

(a) le calcul d'indices de bit $\Pi(0)$ à $\Pi(15)$ du flux de sortie pour des seize premiers indices du flux d'entrée ;
(b) le transfert de K, un résultat de $(128*f_2) \bmod K$ et des indices de bit $\Pi(j)$ et $\Pi(j+8)$ où $0 \leq j \leq 7$, à l'un de huit opérateurs d'indice (220) étant adaptés pour opérer en parallèle ;
(c) le calcul, par les huit opérateurs d'indice (220), de valeurs d'indice de sortie $\Pi(n*8)$, $\Pi(n*8 + 1)$, $\Pi(n*8 + 2)$, $\Pi(n*8 + 3)$, $\Pi(n*8 + 4)$, $\Pi(n*8 + 5)$, $\Pi(n*8 + 6)$, $\Pi(n*8 + 7)$, en parallèle où $2 \leq n \leq K/8 - 1$, dans lequel l'indice pour un (i + j + 16)-ième bit est calculé par un j-ième opérateur d'indice des huit opérateurs d'indice (220) en utilisant une équation suivante :

$$\Pi(i+j+16) = (2*\Pi(i+j+8) - \Pi(i+j) + 128*f_2) \bmod K$$

avec i étant augmenté de huit.

7. Procédé selon la revendication 6, dans lequel l'opération modulaire de l'équation est effectuée en utilisant un additionneur (310) et un multiplexeur (320),

dans lequel l'additionneur (310) additionne le dividende et un diviseur de signe inversé de l'opération modulaire, et le multiplexeur (320) reçoit des entrées du dividende et d'un résultat de l'additionneur (310),
dans lequel le multiplexeur (320) délivre en sortie le dividende quand le résultat de l'additionneur (310) est un nombre négatif et délivre en sortie le résultat de l'additionneur (310) quand le résultat de l'additionneur (310) est un nombre positif.

8. Procédé selon la revendication 6, dans lequel l'opération modulaire de l'équation est effectuée en utilisant un premier additionneur (410), un deuxième additionneur (420) et un multiplexeur (430) par le biais de réceptions d'une première entrée, d'une deuxième entrée et d'un diviseur égal à K.
dans lequel le premier additionneur (410) additionne la première entrée et une deuxième entrée de signe inversé, le deuxième additionneur (420) additionne un résultat de la première addition et K, et le multiplexeur (430) reçoit des entrées du résultat du premier additionneur (410) et d'un résultat du deuxième additionneur (420) et délivre en sortie le résultat du deuxième additionneur (420) quand le résultat du premier additionneur (410) est un nombre négatif et délivre en sortie le résultat du premier additionneur (410) quand le résultat du premier additionneur (410) est un nombre positif.

[Fig. 1]

[Fig. 2]

[Fig. 3]

[Fig. 4]

EP 2 810 372 B1

[Fig. 5]

18

[Fig. 6]

[Fig. 7]

Flowchart:

START

↓

CALCULATE $K, f_1, f_2$
FROM INPUT DATA  —— S710

↓

CALCULATE FROM
$\Pi(i)$ TO $\Pi(i+15)$ BY USING $K, f_1, f_2$  —— S720

↓

DERIVE IN PARALLEL A PLURALITY
INDEXES FOR BITS FROM $\Pi(i+16)$
BY USING DIFFERENCE BETWEEN INDEXES  —— S730

↓

END

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **YANG SUN ET.** Efficient hardware implementation of a highly-parallel 3GPP LTE/LTE-advance turbo decoder. *Integration, The VLSI Journal,* 17 July 2010, vol. 44 (4), ISSN 0167-9260, 305-315